# EUROPEAN PATENT APPLICATION

(11) **EP 4 822 515 A1**
(43) Date of publication of application: **14.10.2026**
(21) Application number: 25169998.9
(22) Date of filing: 11.04.2025
(51) Int. Cl.: G06F 5/01, G06F 5/00, G06F 7/483, G06N 3/063, G06N 20/00, H03M 7/24

(54) **SCALING METHOD FOR MACHINE LEARNING**

(71) Applicant: Forschungszentrum Jülich GmbH, 52428 Jülich (DE)
(72) Inventor: RANA, Dr. Vikas, 52428 Jülich (DE); ISSAC, Dr. Tom Glint, 52428 Jülich (DE)
(74) Representative: Gille Hrabal Partnerschaftsgesellschaft mbB Patentanwälte

(57) **Abstract**

The invention relates to a computer-implemented machine-learning method, a use of a dynamic scaling method, a computer program, a computer-readable medium, a data carrier, a data carrier signal and an electronic device. In a computer-implemented machine-learning method (6), a value (x) is scaled to transform the value (x) into an input value (x') of a following step within a desired range. Scaling is performed dynamically.

## Description

The invention relates to a computer-implemented machine-learning method, a use of a dynamic scaling method, a computer program, a computer-readable medium, a data carrier, a data carrier signal and an electronic device.

In machine learning methods, in particular in deep neural networks, the values, e.g. of data points, can experience significant fluctuation, for example as they propagate through layers. This is also called "ballooning". Values, e.g. of intermediate data, can grow exponentially due to cumulative effects of operations like matrix multiplications, activations and/or normalizations. Ballooning may lead to values which exceed the representable range, in particular when low-precision number systems are used. This may lead to overflow or underflow errors, for example resulting in truncation (cut-off) of values or data corruption, and/or significant precision loss.

Scaling is a transformation in which a value or several values are transformed such that the value or values have a useful property or useful properties. In scaling, the range of data is changed. The value or values may be transformed so that they fit in a scale between, for example, 0 and 1. Scaling usually comprises multiplying the value or values with a scaling factor.

Conventionally, scaling factors are used which take into account the known or expected minimum and maximum values. Scaling factors may be predetermined during model training. If the real-world data used after training differs too much from the training data, the mentioned problems may arise. In one approach, scaling is performed globally. This means that maximum data ranges are known or estimated and computational overhead is added. This may also lead to problems. On the one hand, data can still exceed the predetermined range. On the other hand, the calculated values can be significantly smaller, which also leads to a precision loss.

The above-mentioned definitions, features and properties may be combined individually or in any combination with the aspects, embodiments and features of the invention.

The task of the invention is to provide a further-developed machine-learning method.

The task is solved by the method of claim 1 as well as the use of a dynamic scaling method, the computer program, the computer-readable medium, the data carrier, the data carrier signal and the electronic device according to the additional claims. Preferable embodiments are given in the dependent claims.

A computer-implemented machine-learning method serves to solve the task. At least one value may be scaled, for example to transform the value into an input value of a following step which is within a desired range. In particular, scaling is performed dynamically.

In contrast to the prior art, no fixed or static scaling factor is used. In contrast, scaling factors are determined individually for the specific operation or layer, as described below. Scaling is therefore possible without knowledge of the maximum value. This allows for a dynamic adaptation. In addition, overflow and underflow can be prevented without requiring extensive range checks. This enhances the stability of the machine-learning method. The method allows for real-time applications, for example for adapting to data characteristics in real time.

As described, scaling is used to transform the value or values into a desired range. Dynamic scaling is scaling without a fixed or static scaling factor. Dynamic scaling uses scaling parameters, such as an input bias and/or a scaling factor, which are chosen specifically for the current operation or layer. Therefore, in the next operation or layer, most probably different scaling parameters will be used. In particular, each layer has its own set of scaling parameters. This allows to shift the histogram of the layer output and/or weights such that it is centered around the mean value which may be representable by the chosen number system. This allows to adjust the numbers to be represented by the chosen number system in an improved manner. For example, a scaling factor < 1 may be applied if more than 50% of the values lie outside the range which can be or can be optimally represented by the number system. Scaling parameters can for example be determined empirically, for example by parsing weights and test inference data using an FP32 number system for a given deep neural network architecture.

In conventional methods, scaling is not performed in each layer of a machine-learning method, but only normalization may be performed. In normalization, each value is divided by the largest value, resulting in values between 0 and 1. Due to the floating nature of the floating-point number format, preventing overflow as in conventional methods is not necessary.

In one implementation, the method comprises normalization. In particular, scaling is performed after normalization. In another implementation, after the normalization process, if the range is still outside the range of the number system further biasing (using the input bias) and scaling (using the scaling factor) could be performed. Biasing and scaling are in particular applied uniformly to all values. By doing this, some of the values may be brought into the range of the number system. Some values may be allowed to be truncated to the limits of the range of the number system, as described below. Hence, in some implementations, the input bias can be zero and/or the scaling factor can be 1. It has shown that deep neural networks are robust and allow the weight set to adapt for correct inference.

In particular, dynamic scaling employs adjustment of the value or of parts of the value such as an exponent and/or a mantissa. Dynamic scaling may comprise adjusting one or more values to be within a predefined range. Dynamic scaling may comprise quantizing one or more values. In dynamic scaling, there is in particular no hard truncation or simple cut-off of values which are outside a given range. Therefore, precision is enhanced.

In particular, the method comprises calculating one or more values to propagate from a first layer to a second layer. The first layer can be an input layer or a hidden layer. The second layer can be a hidden layer or an output layer. The following step then relates to the second layer or a calculation in the second layer. In a deep-learning method there may be a plurality of deep layers. For example, both the first and the second layers are hidden layers. Propagation includes back-propagation. The value is in particular intermediate data.

In one configuration, the value is an output value, for example an output value of an n^{th} layer. In particular, the value is scaled to be an input value of a further layer, for example an (n+1)^{th} layer. In particular, scaling is performed to advance propagation through the layers.

In an alternative configuration, the value is part of input data for the machine-learning model. For example, the value is part of a data set or has been calculated from a data set on which the machine-learning model is to infer results or to be trained.

The value is transformed to obtain an input value of or for a following step. The following step can be any step in which the input value is used. In particular, the input value is used for a calculation. The method may comprise performing the following step, in particular using the calculated input value.

For example, scaling is performed to transform an output value of a first layer in order to obtain an input value of a second layer which is in a desired certain range.

In one configuration, the value is a floating-point value. A floating-point value is a value in a floating-point number format. In one configuration, the method comprises transforming an input value to obtain the floating-point value. In particular, the value is present as a 7-bit value, a 6-bit value, or, preferably, as a 5-bit value. Small-bitwidth or low-precision numbers allow for a very time-, energy- and resource-efficient calculations. However, problems such as overflow or underflow errors arise in particular with small-bitwidth numbers. Thus, the dynamic scaling according to the invention allows for efficient calculations while guaranteeing precision.

In one configuration, the value is in a floating-point number format having an exponent and a mantissa, wherein the exponent is asymmetrically biased. In particular, the exponent is asymmetrically biased around zero. For example, the exponent is biased such that a difference between an absolute value of a negative exponent having the maximum absolute value and an absolute value of a positive exponent with the maximum absolute value is at least 2. Therefore, the numbers above 1 and the numbers between 0 and 1 are encoded with a different precision or resolution. For example, if the exponent is encoded with 2 bits, there are 4 values which can be stored, 0, 1, 2, and 3. In order to be asymmetrically biased around zero, the bias can by any number except for -1 (which would result in -1, 0, +1, +2, where |-1| = 1 and |2| = 2, thus the difference between the negative exponent with the maximum absolute value is 1) or -2 (which would result in -2, -1, 0, +1, where |-2| = 2 and |1| = 1, where the difference between the negative exponent with the maximum absolute value is also 1).

In particular, the number format has 2 or 3 exponent bits and 2 or 3 mantissa bits. For example, the number format has at least two exponent bits. Thus, the exponent is encoded with at least two bits. Thus, there are at least four different exponent values which can be encoded.

For example, the number format has at least two mantissa bits. Thus, the mantissa is encoded with at least two bits. Thus, there are at least four different mantissa values which can be encoded.

In particular, the number format further comprises at least one, in particular exactly one sign bit. The sign bit determines the polarity of the number. Typically, 0 is for positive numbers and 1 is for negative numbers.

The number format may be according to the following formula: $F = {\left(-1\right)}^{S} ∗ \left(1+M\right) ∗ {2}^{\left(E+B\right)} ,$ with F being the number to be represented, S being the sign, M being the mantissa, E being the exponent, and B being the bias. The mantissa number format may be according to the following formula: $M = MSB ∗ {2}^{- 1} + LSB ∗ {2}^{- 2} ,$ with M being the mantissa, MSB being the most significant bit of the mantissa and LSB being the least significant bit of the mantissa.

The method is in particular an adaptive machine-learning method. The machine-learning model is in particular an adaptive machine-learning model. Data with unpredictable distributions can be handled particularly well in comparison to conventional methods using static or fixed scaling factors.

In one configuration, the machine-learning method uses a neural network, in particular a quantized neural network. The dynamic scaling is particularly well-suited for maintaining numerical stability. The machine-learning model may be a convolutional neural network or a large language model, for example. The machine-learning model may be a deep neural network.

The method of the invention fits easily into machine-learning processing pipelines. It is configured to operate between matrix multiplication and activation stages. The method is suited to significantly improve numerical stability.

In one configuration, the method further comprises performing a calculation, in particular a multiplication and/or an addition, in particular of a calculated product.

Using a conventional method, if the value is 0.10 and the minimum storable value is 0.125, 0.125 would be stored. Through adjustment of the exponent and the mantissa, and quantization of the mantissa, if necessary, it is possible to still store 0.10. Therefore, the method according to the invention leads to an increased precision while enabling to use a very space-saving number format such as a 5-bit floating-point format. Hard truncation can be avoided. The method can be described as a "soft truncation", as the exponent may be truncated, but the original exponent is still represented in the mantissa.

The method and/or the corresponding computer program controls a computer's internal functioning and operation, as knowledge of the maximum value, i.e. of all data, is not required. Thus, the processor load is reduced. The invention also relates to a method and program for processing code at low level, as a great number of values is not required. This contributes to producing the further technical effect of limiting the resources needed.

A further aspect of the invention is a machine-learning model in which a value is scaled to transform the value into an input value of a following step within a desired range, wherein scaling is performed dynamically. All embodiments, features and advantages of the method described above may also apply to the model and vice versa.

In one embodiment, the value x is preconditioned with a linear transform. An input bias b may be added. Please note that the input bias is not to be confused with the exponent bias or simply bias as described above. Input value x may be multiplied with a scaling factor s, in particular after addition of the input bias b. The following formula may be used: ${x}_{int} = s ⋅ \left(x+b\right) .$

Through the input bias, the value is shifted in the number line. The shifted value is then scaled using the scaling factor which is a multiplier and/or which may be fractional in nature.

In one embodiment, the value (x) or the intermediate value xᵢₙₜ is expressed or present as $x = m ∗ {2}^{e} or {x}_{int} = m ∗ {2}^{e} ,$ with m being a mantissa and e being an exponent. In particular, the value is present in such a form or transformed into such a form. This may be referred to as floating-point decomposition. This yields the mantissa m and the exponent. Thus, the value is expressed in a floating-point number format.

In one embodiment, a constraint is defined for the mantissa. For example, the following applies to the mantissa: 0.5 ≤ |m| < 1. In particular, a constraint is defined such that there is only one solution to express the value in the above-mentioned format.

In one embodiment, the exponent (e) is adjusted to be within a predefined range. In particular, an adjusted exponent e_{adj} is thus obtained.

In other words, the exponent is clamped within the range. The range can be expressed as [eₘᵢₙ, eₘₐₓ]. This ensures that values do not exceed limits of the range. This prevents ballooning. In a simple configuration, values which are smaller than the lower limit of the range may be transformed into the lower limit. In a simple configuration, values which are larger than the upper limit of the range may be transformed into the upper limit. Alternatively, it is basically also possible that values are compressed, for example a plurality of values, to fit in the range.

The concrete values of eₘᵢₙ and eₘₐₓ can be selected based on the specific requirements, in particular taking into account the concrete floating-point number format of the value. Preferably, the difference eₘₐₓ-eₘᵢₙ corresponds to the number of possible exponents. For example, if the number format comprises a two-bit exponent (i.e., there are four different possible values for the exponent), the difference between eₘᵢₙ and eₘₐₓ should preferably be 4. If the number-format comprises a three-bit exponent, the difference should preferably be 8.

Further, in case the value is in a floating-point number format having an asymmetrically biased exponent, eₘᵢₙ should preferably correspond to the bias . This may be the case, in particular, with a negative bias. For example, if the bias is -3, eₘᵢₙ should preferably be -3. For example, eₘₐₓ could then be 0. eₘₐₓ may represent bias + offset.

In one configuration, [eₘᵢₙ, eₘₐₓ] is [-3, 0]. In another configuration, [eₘᵢₙ, eₘₐₓ] is [-7,-4].

The predefined range may be expressed with the following formula: ${e}_{adj} = min \left(B+{2}^{{N}_{e}}-1,max\left(B, e\right)\right)$ with B being the exponent bias, Nₑ being the number of exponent bits and e being the exponent.

Adjusting the exponent to be within a predefined range may be performed by using the following formula: ${e}_{adj} = max \left({e}_{min},min\left(e, {e}_{max}\right)\right) .$

In other words, values above the maximum eₘₐₓ are cut off such as values below the minimum eₘᵢₙ. Thus, the resulting adjusted exponent is within the predefined range. In particular, also the actual exponent is used for further calculation. In this case, no actual exponent cutoff is performed.

In one embodiment, the mantissa is adjusted, in particular using the adjusted exponent, for example using the following formula: ${m}_{adj} = m ∗ {2}^{\left(e-{e}_{adj}\right)} ,$ with m_{adj} being the adjusted mantissa, e being the exponent and e_{adj} being the adjusted exponent. Adjusting the mantissa in particular leads to an adjusted mantissa m_{adj}.

In particular, mantissa adjustment (which may also be referred to as mantissa scaling) is performed based on the difference between the original and adjusted exponents.

Adjusting the mantissa is particularly preferable when the exponent has been adjusted to be in a predefined range. In this case, using the exponent, in particular in addition to the adjusted exponent, guarantees that the exponent values outside the predetermined range are not cut off but still considered. This increases precision and model stability.

Basically, mantissa adjustment can be performed first, and then the exponent can then be adjusted based on the adjusted mantissa.

In one embodiment, the mantissa, in particular the adjusted mantissa, is quantized. Quantizing the mantissa in particular leads to a quantized mantissa m_{quant}.

Through quantization, precision is reduced. Quantization may be performed by or include truncating or cutting off values, for example values larger than a largest possible mantissa value may be transformed into the largest possible mantissa value. Quantization may be performed by or include rounding.

In one embodiment, quantization comprises following the following formula: ${m}_{quant} = \frac{round \left({m}_{adj}∗Q\right)}{Q} ,$ with m_{quant} being the quantized mantissa, m_{adj} being the adjusted mantissa and Q being the quantization level. In particular, the mantissa is quantized to the nearest multiple of 1/Q.

Q is the quantization level, i.e., the number of possible values. For example, if 2-bit quantization is performed, Q = 4. In case of 3-bit quantization, Q = 8 and so on. For two-bit quantization, the allowed values are in particular 0, 0.25, 0.5, and 0.75.

Rounding may be performed by using a certain number of bits only, e.g. two bits only, for example the most significant bits, e.g. after the first bit. If exponent and/or mantissa are adjusted beforehand, rounding limits the bitwidth without reducing the precision too much.

The round function serves for rounding. In particular, the round function computes the nearest integer value to the argument (arg), in particular rounding halfway cases away from zero, in particular regardless of the current rounding mode.

Rounding ensures that errors are symmetrically distributed and therefore minimizes bias.

In one embodiment, 4-bit quantization, 3-bit quantization or preferably 2-bit quantization is performed.

Quantization is performed for minimal loss within the critical data range. It has been shown that 2-bit quantization, allowing for four values 0, 0.25, 0.5, and 0.75 offers maximum quantization at still low losses in the critical data range. Hardware efficiency and computational fidelity are balanced to an optimum.

In one embodiment, the scaled value is reconstructed, in particular using the adjusted mantissa (q_{adj}), the quantized mantissa (m_{quant}) and/or the adjusted exponent (e_{adj}).

In one configuration, the scaled value is reconstructed according to the following formula: $x ′ = {m}_{quant} ∗ {2}^{{e}_{adj}} ,$ with x' being the scaled value, m_{quant} being the quantized mantissa and e_{adj} being the adjusted exponent.

In particular, the input value x' of the following step is calculated as follows: $x ′ = \left\{\begin{matrix}0 , if x ′ = 0 \\ sign \left(x\right) ∗ {m}_{quant} ∗ {2}^{{e}_{adj}} , otherwise\end{matrix}\right.$

Intermediate steps to arrive at this are described in detail above.

In particular, the value is a real number, the input bias is a real number, the scaling factor is a real number, the number of mantissa bits is a natural number, the number of exponent bits is a natural number and the exponent bias is an integer.

In one configuration, the method is a training method. In one configuration, the method is an inference method.

In one embodiment, the method is a real-time inference method. Real time typically means that results are produced and/or output substantially directly, i.e., without significant delay. In particular, in a real-time method, inference is performed while input data is still input or received. In particular, output data is already produced or output while input data is still input or received. Thus, output data can be produced without knowing a maximum value of the input data used.

In one configuration, the method is a real-time method.

A further aspect of the invention is a use of a dynamic scaling or dynamic scaling method for scaling a value (x) to transform the value (x) into an input value within a desired range in a machine learning model. The model is in particular computer-implemented. The dynamic scaling method may comprise or be the computer-implemented machine-learning method according to the invention. All embodiments, features and advantages of the method and the model described above may also apply to the use and vice versa.

A further aspect is a computer program comprising instructions, which, when executed on a computer, perform the method according to the invention. All embodiments, features and advantages of the method, the model and the use described above may also apply to the computer program and vice versa.

Computer is a broad term. A computer in the sense of the invention is an electronic machine that can be programmed to automatically carry out sequences of arithmetic or logical operations (computation), in particular programs. In particular, the computer comprises at least one processing element, typically a microprocessor, and a computer memory, such as a semiconductor memory chips. A computer can also be referred to as computing unit.

A further aspect is a computer-readable medium, comprising instructions, which, when executed on a computer, perform the method according to the invention. A further aspect is a data carrier, comprising instructions, which, when executed on a computer, perform the method according to the invention. A further aspect is a data carrier signal, comprising instructions, which, when executed on a computer, perform the method according to the invention. All embodiments, features and advantages of the aspects described above may also apply to these aspects and vice versa.

A further aspect is an electronic device, comprising a processor and a computer program or a computer-readable medium comprising instructions which, when executed on the processor, performs the method according to the invention. All embodiments, features and advantages of the aspects described above may also apply to the electronic device and vice versa.

The electronic device may comprise a decomposition unit for expressing the input value as $x = m ∗ {2}^{e} .$

The electronic device may comprise an exponent adjusting unit for adjusting the exponent to be within a predefined range [eₘᵢₙ, eₘₐₓ]. In particular, the exponent adjusting unit comprises one or more specialized and/or efficient comparison circuits for efficiently performing min-max operations. For example, the electronic device has access to the values of eₘᵢₙ and eₘₐₓ. In particular, the values eₘᵢₙ and eₘₐₓ and/or the bias are not included in the number format of value (x). Thus, these values are not represented in the number format, not even in a coded form. Therefore, these values cannot be derived from a number represented in the number format. The values eₘᵢₙ and eₘₐₓ and/or the bias may therefore be coded in the hardware of the electronic device, for example hardwired or stored/ kept floating using a storage means such as a register.

The electronic device may comprise a mantissa adjusting unit for adjusting the mantissa, in particular using the adjusted exponent. In particular, the mantissa adjusting unit comprises a shift register for performing exponent adjustments.

The electronic device may comprise a quantization unit for quantizing the mantissa, in particular using the mentioned formula. In particular, the quantization unit comprises one or more preferably simple rounding circuits which may serve for minimizing gate count.

The electronic device may comprise a recomposition unit to reconstruct or calculate the scaled value. The recomposition unit may also be referred to as calculation unit.

Each of the mentioned units are in particular included in a computer and/or processor of the electronic device.

In one embodiment, the electronic device is a machine-learning accelerator or forms part of a machine-learning accelerator.

A machine-learning accelerator, also known as a neural processing unit, is a specialized hardware accelerator or computer system designed to accelerate artificial intelligence and machine learning applications.

In one configuration the electronic device is a multiply-accumulate (MAC) unit of a machine-learning accelerator. A MAC unit is a fundamental unit for performing MAC operations. MAC operations are a basic calculation operation used in machine learning and other types of digital data processing. Typically, two factors are multiplied and the product is added to an accumulator. Accumulation can be used to calculate integration; multiplication can be used for weighing or to consider a differential of a function, for example.

In one embodiment, the electronic device is an edge-computing device.

In edge computing, computing and data storage are brought closer to the data sources or to where requests are made. In comparison to cloud servers, for example, edge-computing devices, also referred to as edge devices, are devices that are closer to the data sources, data destinations and/or to the user. This reduces latency compared to centralized data centers. Edge computing occurs outside the cloud, at the network's edge, particularly for applications which need immediate data processing. In particular, an edge device is a standalone unit which performs operations itself, for example Al applications. The edge device may be an IoT device.

### Example:

In one exemplary configuration, an algorithmic implantation of the invention may be as follows (using the programming language C)

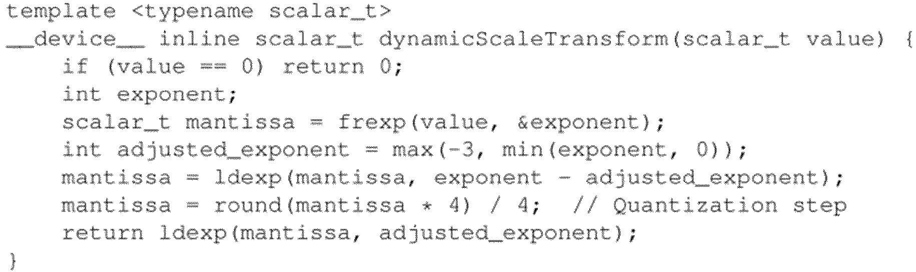

In the following, exemplary embodiments of the invention are shown using figures. The features of the figures can be combined individually or in combination with other features. The figures are not limiting.

The figures show:
- Figure 1:: a schematic representation of a machine-learning method;
- Figure 2:: a schematic representation of a number format and an electronic device;
- Figure 3:: a schematic representation of a deep neural network; and
- Figure 4:: a computer program, a computer-readable medium, a data carrier, or a data carrier signal.

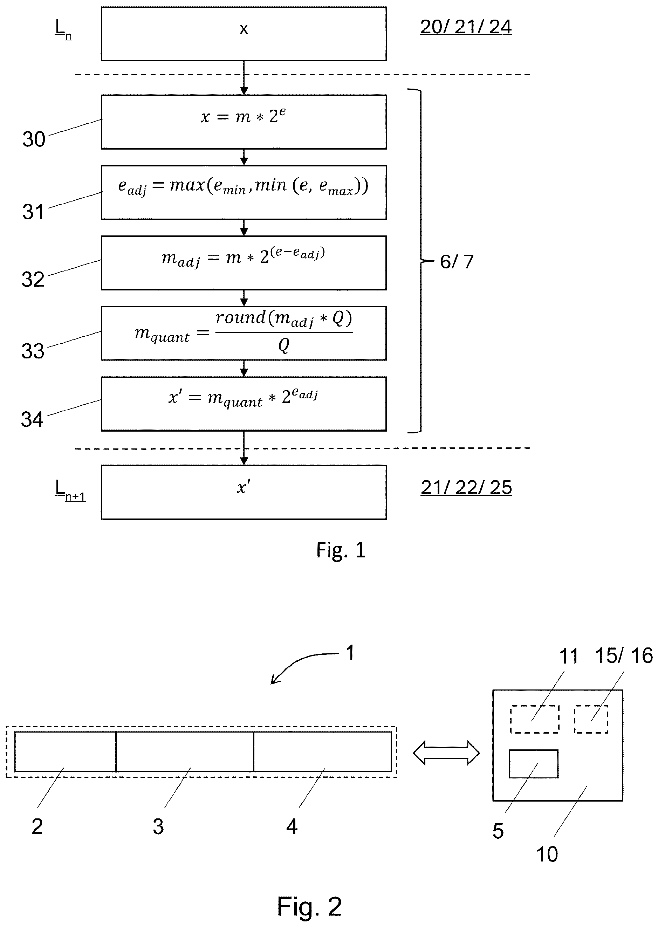

Figure 1 schematically shows a machine-learning method 6 or a dynamic scaling method 7 and its arrangement in a workflow. On top, the n^{th} layer Lₙ is represented. Layer Lₙ may be an input layer 20 or a hidden layer 21. In the case of an input layer 20, the input value x may be raw input data 24. In case of a hidden layer 21, the input value x may be output data of a previous layer. This previous layer may again be an input layer or a hidden layer.

Input value x is used as input for the method 6 or the dynamic scaling method 7, in which an input value x' of a following step is calculated. In other words, the input value x is scaled to be transformed into the input value x' of the following step. The following step is in particular the (n+1)^{th} layer Lₙ₊₁ which may be a hidden layer 21 or an output layer 22. In case of a hidden layer 21, input value x' represents an input value for this hidden layer 21. In case of an output layer 22, input value x' represents an output value to be output.

The exemplary configuration of the method 6 or 7 shown in Figure 1 may comprise a step of decomposition 30 in which the value x is expressed for example according to the shown formula. In particular, 0.5 ≤ |m| < 1. It may comprise a step of exponent adjustment 31 in which the exponent is adjusted to be within a predefined range, for example according to the shown formula. It may further comprise a step of mantissa adjustment 32 in which the mantissa is adjusted, in particular using the adjusted exponent, for example according to the shown formula. The method may further comprise a step of quantization 33, in particular mantissa quantization, in which the mantissa is quantized, for example according to the shown formula. It may further comprise a step of recomposition, in which the scaled value is reconstructed, for example according to the shown formula. The reconstructed value corresponds to the input value x'.

In Figure 1, the method 6 or 7 is shown between the layer Lₙ and the layer Lₙ₊₁. However, this is merely exemplary to show its position in the course of a machine-learning training or inference method. The step or steps of the method 6 or 7 may be attributed to layer Lₙ or layer Lₙ₊₁, for example.

It is to be noted that each of the steps 30 to 34 is optional. Some steps may be omitted or replaced by other steps. If possible, the order (sequence) of steps may be changed. The shown sequence is purely exemplary. For example, the mantissa adjustment could be performed first, and then the exponent could be adjusted based on the adjusted mantissa.

In one configuration, the method according to the invention is performed in each pair of consecutive layers of a machine-learning model.

Figure 2 shows on the left-hand side a schematic representation of the computer-implemented floating-point number format 1 which may be used. The number format 1 comprises a sign 2, a mantissa 3 and an exponent 4. By way of example, the size of the respective fields shows the storage space of the single components. In particular, the sign 2 has 1 bit. In particular, the mantissa 3 has 2 bits. In particular, the exponent 4 has two bits. The exponent 3 is asymmetrically biased using a bias which is preferably not included in the number format 1 itself.

On the right-hand side, an electronic device 10 is schematically shown. In particular, the electronic device 10 interacts with the number format in such a way that calculations are performed by the electronic device 10 using the number format. Preferably, the electronic device includes the bias 5, for example in a hardwired and/or electronically stored way. In this case, an electronic device 10 having the bias 5 is required for interpreting the value stored in the number format.

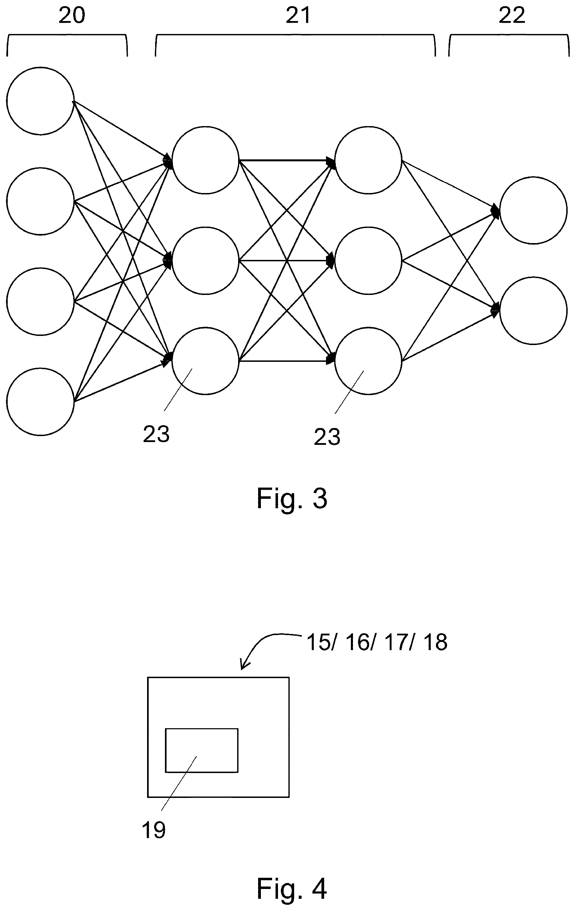

The electronic device 10, which is an individual aspect of the invention, in particular also comprises a processor 11. The electronic device 10 may further comprise a computer program 15 and/or a computer-readable medium 16 comprising instructions, which, when executed on the processor, performs a calculation using the floating-point number format 1. The computer program 15 and the computer-readable medium 16 are also depicted in Figure 4.

Figure 3 shows a simplified schematic of a deep neural network. There is an input layer 20 into which input data or raw data is input. There is a number of hidden layers 21 and there is an output layer 22 through which data is output. By way of example, only two hidden layers 21 are shown. However, deep neural networks usually have far more hidden layers 21, in particular more than hundreds or thousands of hidden layers 21. Each layer 20, 21, 22 comprises artificial neurons 23 which act as nodes. Neurons 23 apply a transformation of their inputs and pass processed data to the next layer.

Neurons 23 of the input layer 20 correspond to features of the input, such as pixel intensities in an image, words in a sentence of numerical attributes in structured data, for example. In particular, neurons 23 in the hidden layers 21 perform non-linear transformations by applying activation functions to weighed sums of inputs. Deeper networks with multiple hidden layers 21 can extract hierarchical and abstract features from raw data, for example. The output layer 22 produces the desired result depending on the specific task, such as a prediction or classification result. For classification tasks, the output layer typically employs a softmax function to generate probabilities, while for regression tasks, a linear activation function may be used.

The connectivity between neurons is governed by weights, which determine the influence of each input on the neuron's output. Bias terms may also be included to allow for flexible transformations. Weights are adapted or optimized during a learning phase. During forward propagation, for example, input data passes through the network layer by layer. At each neuron 23, a weighed sum of inputs is computed, followed by the application of an activation function. Different activation functions may be used, such as Sigmoid, ReLU (Rectified Linear Unit) or Tanh. In particular, the activation function used introduces non-linearity, thus enabling the network to learn complex mappings.

Loss functions may be used to evaluate network performance. Loss functions quantify the error between the predicted and actual outputs. Once the loss is computed, gradient-based optimization algorithms adjust the weights using back-propagation. This may involve computing gradients of the loss with respect to each weight using the chain rule of differentiation and updating weights.

In particular, a training set of values is used for training, in particular updating model weights through back-propagation. In particular, a validation set is used for validation, in particular for tuning hyperparameters and/or monitoring performance, e.g., to prevent overfitting. In particular, a test set is used to evaluate the final model's performance on different (unseen) data.

Each of the mentioned calculations and functions, alone or in any combination, may be part of the method according to the invention.

Figure 4 shows a computer program 15, a computer-readable medium 16, a data carrier 17, or a data carrier signal 18, comprising instructions 19 which, when executed on a computer, perform a the method according to the invention.

**List of Reference Signs**

| | |
|---|---|
| Number format | 1 |
| Sign | 2 |
| Exponent | 3 |
| Mantissa | 4 |
| Bias | 5 |
| Method | 6 |
| Dynamic scaling method | 7 |
| Electronic device | 10 |
| Processor | 11 |
| Training method | 12 |
| Inference method | 13 |
| Calculation | 14 |
| Computer program | 15 |
| Computer-readable medium | 16 |
| Data carrier | 17 |
| Data carrier signal | 18 |
| Instructions | 19 |
| Input layer | 20 |
| Hidden layer | 21 |
| Output layer | 22 |
| Neuron | 23 |
| (Raw) input data | 24 |
| Output data | 25 |
| Decomposition | 30 |
| Exponent adjustment | 31 |
| Mantissa adjustment | 32 |
| Quantization | 33 |
| Recomposition | 34 |
| N^{th} layer | Lₙ |
| (n+1)^{th} layer | Lₙ₊₁ |
| Value | x |
| Input value | x' |
| Intermediate value | xᵢₙₜ |
| scaling factor | s |
| input bias | b |
| Mantissa | m |
| Adjusted mantissa | m_{adj} |
| Quantized mantissa | m_{quant} |
| Exponent | e |
| Adjusted exponent | e_{adj} |
| Quantization level | Q |

## Claims

1. A computer-implemented machine-learning method (6) in which a floating-point value (x) is scaled to transform the value (x) into an input value (x') of a following step within a desired range, wherein scaling is performed dynamically.

2. The method (6) of the preceding claim, wherein the value (x) is subjected to a linear transform according to the following formula: ${x}_{int} = s ⋅ \left(x+b\right) ,$ with xᵢₙₜ being an intermediate value, b being an input bias and s being a scaling factor.

3. The method (6) of one of the preceding claims, wherein a floating-point decomposition of the value (x) or the intermediate value (xᵢₙₜ) is performed according to the following formula: $x = m ∗ {2}^{e} or {x}_{int} = m ∗ {2}^{e} ,$ with m being a mantissa and e being an exponent.

4. The method (6) of the preceding claim, wherein a constraint is defined for the mantissa according to the following formula: $0.5 \leq \left|m\right| < 1 .$

5. The method (6) of one of the preceding claims, wherein the exponent (e) is adjusted to be within a predefined range.

6. The method (6) of one of the two preceding claims, wherein the mantissa (m) is adjusted, in particular using the adjusted exponent (e_{adj}), for example using the following formula: ${m}_{adj} = m ∗ {2}^{\left(e-{e}_{adj}\right)} ,$ with m_{adj} being the adjusted mantissa, e being the exponent and e_{adj} being the adjusted exponent.

7. The method (6) of one of the three preceding claims, wherein the mantissa (m), in particular the adjusted mantissa (m_{adj}), is quantized, in particular using the following formula: ${m}_{quant} = \frac{round \left({m}_{adj}∗Q\right)}{Q} ,$ with m_{quant} being the quantized mantissa, m_{adj} being the adjusted mantissa and Q being the quantization level.

8. The method (6) of one of the two preceding claims, wherein 4-bit quantization, 3-bit quantization or preferably 2-bit quantization is performed.

9. The method (6) of one of the preceding claims, wherein the scaled value is reconstructed,
in particular using the following formula: $x ′ = {m}_{quant} ∗ {2}^{{e}_{adj}} ,$ with x' being the scaled value, m_{quant} being the quantized mantissa and e_{adj} being the adjusted exponent.

10. The method (6) of one of the preceding claims, wherein the method (6) is a real-time inference method.

11. A use of a dynamic scaling for scaling at least one value (x) to transform the value (x) into an input value (x') of a following step within a desired range in a machine learning model.

12. A computer program (15) comprising instructions (19), which, when executed on a computer, perform the method (6) according to one of the claims 1 to 9.

13. A computer-readable medium (16) or a data carrier (17) or a data carrier signal (18), comprising instructions (19), which, when executed on a computer, perform the method (6) according to one of the claims 1 to 9.

14. An electronic device (10), comprising a processor (11) and a computer program (15) or a computer-readable medium (16) comprising instructions (19) which, when executed on the processor, performs the method (6) according to one of the claims 1 to 9.

15. The electronic device (10) of claim 14, wherein the electronic device (10) is a machine-learning accelerator or forms part of a machine-learning accelerator, or wherein the electronic device (10) is an edge-computing device.
